# EUROPEAN PATENT APPLICATION

(11) **EP 4 685 848 A2**
(43) Date of publication of application: **28.01.2026**
(21) Application number: 25186943.4
(22) Date of filing: 02.07.2025
(51) Int. Cl.: H01L 23/495, H01L 21/60

(54) **CORNER STRESS REDUCTION IN SEMICONDUCTOR ASSEMBLIES**

(30) Priority: 05.07.2024 CN 202410905405
(71) Applicant: Littelfuse Semiconductor (Wuxi) Co., Ltd., Wuxi, Jiangsu 214142 (CN)
(72) Inventor: Hughes, Rhodri, Wuxi, 214142 (CN); Wang, Mathias, Wuxi, 214142 (CN)
(74) Representative: Arnold & Siedsma

(57) **Abstract**

A semiconductor assembly, a packaging structure, and associated method for corner stress reduction in semiconductor devices. The assembly includes a plurality of semiconductor dies and a plurality of spacers. Each spacer in the plurality of spacers is disposed between and configured to separate two semiconductor dies in the plurality of semiconductor dies. At least one spacer in the plurality of spacers has at least one extended spacer corner feature configured to extend toward at least one corner of at least one semiconductor die in the plurality of semiconductor dies disposed adjacent to the at least one spacer. At least one extended spacer corner feature is configured to reduce stress on at least one semiconductor die.

## Description

### TECHNICAL FIELD

This disclosure relates generally to the field of semiconductor devices, and in particular, to corner stress reduction in semiconductor assemblies.

### BACKGROUND

Semiconductor manufacturing is a complex process that faces several challenges. Common defects in semiconductor manufacturing include voids, dislocations, impurities, die cracking, corner chipping, stress fractures, and other issues. Voids are empty spaces within the material that can cause electrical failure due to the lack of conductivity. Dislocations are misalignments in the crystal structure that can disrupt the electronic properties of the semiconductor. Impurities, or contaminants, can be introduced during various stages of manufacturing and can alter the electrical characteristics of the semiconductor. Fractures can occur due to mechanical stress during, for example, cutting processes or from thermal expansion mismatches during subsequent processing steps. Even minor cracks can lead to device failure. Corner chipping is often caused by mechanical means during, for instance, wafer dicing. Corner fractures or chippings can also propagate cracks that lead to device failures, yield losses, etc. Other issues like oxidation, particle contamination, and photolithography misalignment also pose challenges, affecting the performance and yield of semiconductor devices. As devices become thinner and more densely packed, these issues are exacerbated, making manufacturing processes even more delicate and demanding precision to ensure integrity and reliability of final semiconductor devices. Existing semiconductor manufacturing techniques do not sufficiently address these issues.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to a semiconductor assembly. The assembly may include a plurality of semiconductor dies and a plurality of spacers. Each spacer in the plurality of spacers may be disposed between and configured to separate two semiconductor dies in the plurality of semiconductor dies. At least one spacer in the plurality of spacers may have at least one extended spacer corner feature configured to extend toward at least one corner of at least one semiconductor die in the plurality of semiconductor dies may be disposed adjacent to at least one spacer. At least one extended spacer corner feature may be configured to reduce stress on at least one semiconductor die.

The current subject matter includes one or more of the following optional features. At least one extended spacer corner feature may be configured to at least partially cover the at least one corner of the at least one semiconductor die.

At least one extended spacer corner feature may be configured to extend over and beyond at least one corner of at least one semiconductor die at a first predetermined distance from the at least one corner. At least one extended spacer corner feature may be configured to extend over and beyond at least one corner of at least one semiconductor die at a second predetermined distance from at least one corner, where the second predetermined distance may be greater than the first predetermined distance.

The semiconductor assembly may include a plurality of lead frames, and a clip having a first end coupled to a top semiconductor die in the plurality of semiconductor dies and a second end coupled to a first lead frame in the plurality of lead frames, where the top semiconductor die may be disposed at a top of the semiconductor assembly. At least one second lead frame in the plurality of lead frames may be coupled to a bottom spacer in the plurality of spacers. The clip may include a contact area. The contact area of the clip may be configured to cover an entirety of an area of the top semiconductor die. The contact area of the clip may include at least one extended contact corner feature positioned at at least one corner of the contact area. At least one extended contact corner feature may be configured to extend over and beyond at least one corner of the top semiconductor die.

At least one spacer may be a copper spacer.

At least one extended spacer corner feature may have at least one portion having a semicircular shape.

The semiconductor assembly may include a housing configured to encapsulate the plurality of semiconductor dies and the plurality of spacers. The housing may be an epoxy molding compound housing.

Each spacer in the plurality of spacers may be soldered to at least one semiconductor die disposed adjacent to the spacer.

The current subject matter also relates to a packaging structure preferably comprising the semiconductor assembly. The structure may include a housing, a plurality of semiconductor dies, and a plurality of spacers, each spacer in the plurality of spacers may be disposed between and configured to separate two semiconductor dies in the plurality of semiconductor dies. At least one spacer in the plurality of spacers may have at least one extended spacer corner feature configured to extend toward at least one corner of at least one semiconductor die in the plurality of semiconductor dies disposed adjacent to the at least one spacer. At least one extended spacer corner feature may be configured to reduce stress on at least one semiconductor die. The structure may also include a clip having a first end coupled to a top semiconductor die in the plurality of semiconductor dies and a second end coupled to a lead frame in a plurality of lead frames. The top semiconductor die may be disposed at a top of the semiconductor assembly. The housing may be configured to encapsulate the plurality of semiconductor dies, the plurality of spacers, the clip, and at least a portion of the plurality of lead frames. The packaging structure may be configured to incorporate one or more of the optional features discussed herein.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

FIG. 1A shows a perspective three-dimensional view of a semiconductor assembly;
FIG. 1B illustrates a side two-dimensional view of the semiconductor assembly shown in FIG. 1A;
FIG. 1C illustrates a top view of a spacer and a semiconductor die of the semiconductor assembly shown in FIG. 1A.
FIG. 2 illustrates an example of a semiconductor assembly, according to the current subject matter;
FIG. 3A shows a side two-dimensional view of a semiconductor assembly, according to the current subject matter;
FIG. 3B illustrates a top view of a spacer and a semiconductor die of the semiconductor assembly shown in FIG. 1A;
FIG. 3C illustrates a top view of an extended spacer corner feature of the semiconductor assembly shown in FIG. 1A;
FIG. 3D illustrates a top view of another extended spacer corner feature of the semiconductor assembly shown in FIG. 1A;
FIG. 4A shows a two-dimensional side view of a semiconductor assembly, according to the current subject matter;
FIG. 4B illustrates a top view of a spacer and a semiconductor die of the semiconductor assembly shown in FIG. 4A;
FIG. 4C illustrates a top view of the spacer of the semiconductor assembly shown in FIG. 4A;
FIG. 4D shows a two-dimensional side view of another semiconductor assembly, according to the current subject matter;
FIG. 4E illustrates a top view of a spacer and a semiconductor die of the semiconductor assembly shown in FIG. 4D;
FIG. 4F illustrates a top view of extended spacer corner feature(s) of the semiconductor assembly shown in FIG. 4D;
FIG. 5A illustrates top and side views of another semiconductor assembly, according to the current subject matter;
FIG. 5B illustrates top and side views of yet another semiconductor assembly, according to the current subject matter; and
FIG. 5C illustrates top and side views of a further semiconductor assembly, according to the current subject matter.

### DETAILED DESCRIPTION

Various approaches in accordance with the present disclosure will now be described more fully hereinafter with reference to the accompanying drawings.

To address these and potentially other deficiencies of currently available solutions, the current subject matter relate to methods, systems, articles of manufacture, and the like that can, among other possible advantages, provide corner stress reduction in semiconductor assemblies.

Packaging an integrated circuit is typically a final stage of a semiconductor device fabrication process. During packaging, a semiconductor die, which represents the core of a semiconductor device, is encased in a housing that protects the die against physical damage and corrosion. For example, semiconductor dies are commonly mounted on a copper substrate, using solder alloy reflow, conductive epoxy, etc. The mounted semiconductor die is often then encapsulated within a plastic or epoxy compound.

Stress levels in multiple stacked semiconductor dies during packaging are a critical aspect of semiconductor manufacturing, especially with the advent of 3D packaging technologies like through-silicon vias (TSVs). The process of stacking dies introduces various mechanical stresses due to the differences in coefficients of thermal expansion (CTEs) among the different materials used.

At the die level, high thermal stress can lead to several reliability issues, such as, for example, extrusion of TSVs, cracking of the silicon chip, and changes in carrier mobility around the TSVs. These stresses are generated when there is a temperature change during the packaging process, as the materials expand or contract at different rates due to their distinct CTEs.

At the package level, thermal stress can cause warpage in multilayered structures, which is a significant reliability concern. Additionally, moisture stress, which includes both hygroscopic stress and the pressure of water vapor, can also affect the reliability of the packaged dies.

Moreover, die-to-die stress is becoming increasingly important to identify and plan for, particularly at advanced nodes and in advanced packages. A simple mismatch in the interface can impact the device's performance, power, and reliability over its lifetime. Thus, managing stress levels in multiple stacked semiconductor dies during packaging is essential for ensuring performance and longevity of the device.

The current subject matter relates to a semiconductor assembly that may be configured reduce stress on one or more semiconductor dies in the assembly, and, in particular, to corners of such dies. The assembly may include a plurality of semiconductor dies and a plurality of spacers. The semiconductor dies and/or spacers may be configured to have square or rectangular shapes. As can be understood, the dies and/or the spacers may be configured to have any desired shape.

Each spacer may be positioned or disposed adjacent to and between two semiconductor dies. Each spacer may be configured to separate two semiconductor dies and may be soldered to at least one semiconductor die disposed adjacent to the spacer. One or more spacers in the assembly may be configured to include at least one extended spacer corner feature. The extended spacer corner features may be configured to radially extend away from the center of the spacer in diagonal direction and toward at least one corner of at least one semiconductor die that is disposed adjacent to the spacer. Extension of the extended spacer corner feature toward corners of the adjacent semiconductor dies may be configured to at least partially cover one or more corners of the adjacent dies. Alternatively, or in addition, extended spacer corner feature(s) may be configured to extend over and beyond one or more corners of the adjacent semiconductor die(s) at a first predetermined distance from the corner(s) of the adjacent semiconductor die(s). One or more extended spacer corner feature(s) may be configured to extend over and beyond one or more corners of the adjacent semiconductor die(s) at a second predetermined distance from one or more corner(s) of the dies. The second predetermined distance may be greater than the first predetermined distance. The extended spacer corner feature may have at least one portion having a semicircular shape. The spacer may be a copper spacer and/or any other type of spacer. Thus, by having spacers with the extended spacer corner feature(s), the semiconductor assembly may be configured to reduce stress on one or more semiconductor dies.

The semiconductor assembly may also include one or lead frames (e.g., for connection to various electronic/electrical elements of a circuit where the assembly may be positioned). The assembly may also include a clip that may have a first end coupled to a top semiconductor die of the assembly (i.e., semiconductor die disposed at the top of the assembly) and a second end coupled to a lead frame. Another lead frame of the assembly may be coupled to a bottom spacer (that may be disposed at the bottom of the assembly). The clip may include a contact area that may be configured to cover an entirety of an area of the top semiconductor die. Moreover, the contact area may include at least one extended contact corner feature positioned at at least one corner of the contact area. At least one extended contact corner feature may be configured to extend over and beyond at least one corner of the top semiconductor die.

The assembly may include a housing configured to encapsulate the plurality of semiconductor dies and the plurality of spacers. The housing may be an epoxy molding compound housing.

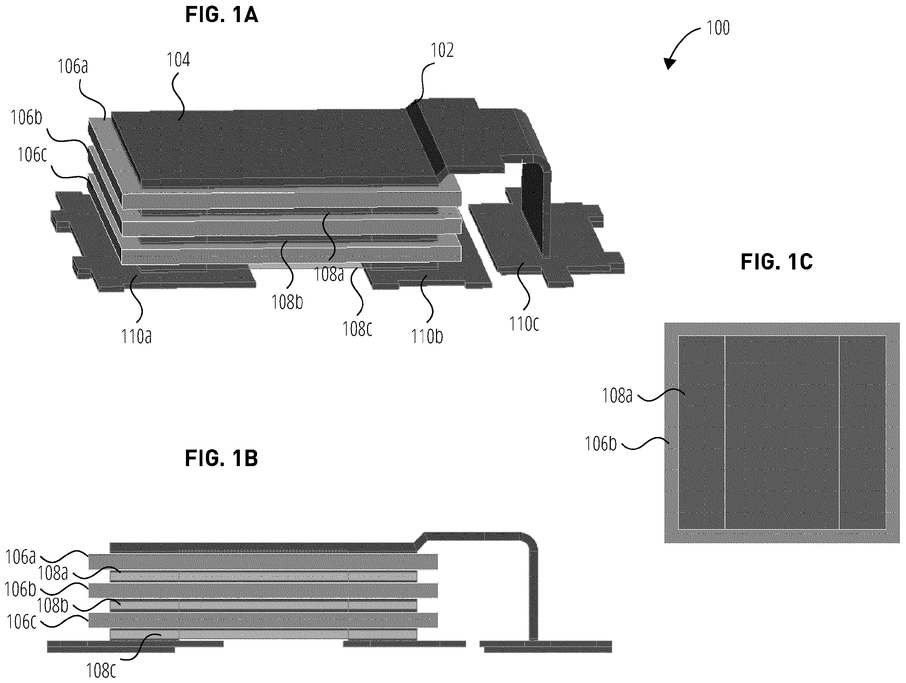

FIGS. 1A-C illustrate an example of a semiconductor assembly 100. FIG. 1A shows a perspective three-dimensional view of the semiconductor assembly 100. FIG. 1B illustrates a side two-dimensional view of the semiconductor assembly 100. FIG. 1C illustrates a top view of a spacer and a semiconductor die of the semiconductor assembly 100.

The semiconductor assembly 100 can include stacked semiconductor dies 106 (a, b, c) separated by spacers 108 (a, b, c). The spacer(s) 108 can be soldered to semiconductor die(s) 106 disposed adjacent to the respective spacer(s) 108. Each spacer 108 can be disposed between and adjacent to, and configured to separate two semiconductor dies 106, as shown in FIGS. 1A and 1B. For example, spacer 108a is configured to separate semiconductor die 106a and semiconductor die 106b, and spacer 108b is configured to separate semiconductor die 106b and semiconductor die 106c. The spacer 108c is disposed on a bottom side of the bottom semiconductor die 106c and can separate the semiconductor die 106c from the lead frame 110a and lead frame 110b. The spacers 108 can be copper spacers and/or can be manufactured from any other desired material. As shown in FIG. 1C, spacers 108 can have a surface area that is smaller than the surface area of the semiconductor dies 106 on which they are positioned. As shown in FIG. 1C, the surface area of the semiconductor die 106b is greater than the surface area of the spacer 108a, which is positioned adjacent to the semiconductor die 106b.

The semiconductor assembly 100 can also include clip 102. The clip 102 can have a first end, i.e., contact area 104, coupled to the top semiconductor die 106a and a second end coupled to the lead frame 110c. The contact area 104 can be configured to substantially cover most of the top surface of the semiconductor die 106a. The lead frame 110c can be separate from the lead frame 110a and lead frame 110b. The lead frames 110 along with clip 102 can be configured to provide electrical connection to one or more electronic components of a circuit (not shown in FIGS. 1A-C) where the semiconductor assembly 100 can be disposed.

The semiconductor assembly 100 can be configured to be encapsulated into a housing (not shown in FIGS. 1A-C). The housing can be an epoxy molding compound housing. As can be understood, any other type of housing may be used to encapsulate the semiconductor assembly 100.

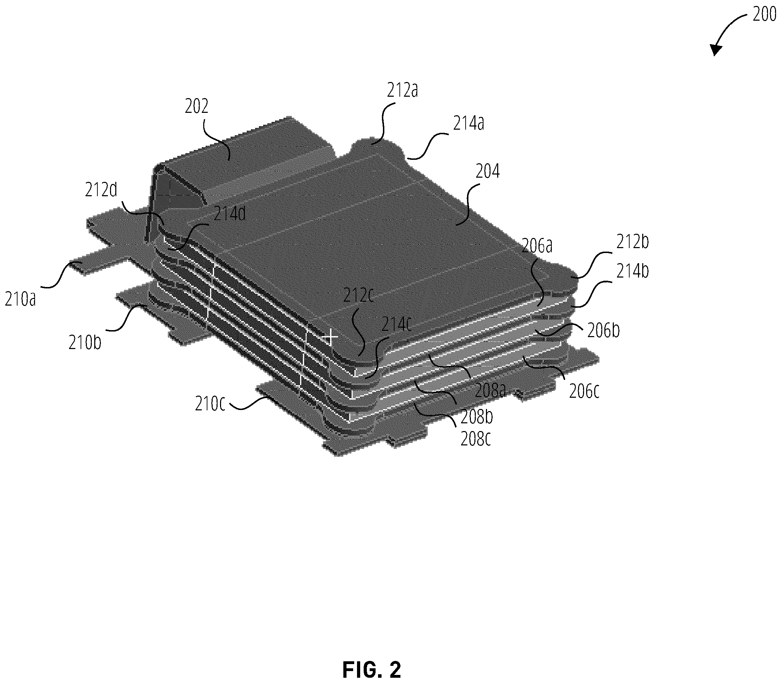

FIG. 2 illustrates an example of a semiconductor assembly 200, according to the current subject matter. The semiconductor assembly 200 may include stacked semiconductor dies 206 (a, b, c) separated by spacers 208 (a, b, c). The semiconductor assembly 200 may also, optionally, include a clip 202 having a contact area 204 or a first end that may be coupled to the top semiconductor die 206a and a second end coupled to the lead frame 210c. The contact area 204 may be configured to cover the entirety (or substantially the entirety) of the top surface of the semiconductor die 206a. Further, the semiconductor assembly 200 may also include lead frame 210a and lead frame 210b that may be separate from the lead frame 210c, where the lead frames 210 and the clip 202 may provide electrical connection to electronic components of a circuit (not shown in FIG. 2) where the semiconductor assembly 200 may be positioned.

Alternatively, or in addition, the semiconductor assembly 200 may be encapsulated into a housing (not shown in FIG. 2). The housing may be an epoxy molding compound housing. As can be understood, any other type of housing may be used to encapsulate the semiconductor assembly 200.

As shown in FIG. 2, the spacer(s) 208 may be soldered to adjacent semiconductor die(s) 206. Each spacer 208 may be disposed between and adjacent to, and may separate two semiconductor dies 206. For example, spacer 208a may be soldered to and separate semiconductor die 206a and semiconductor die 206b. Similarly, spacer 208b may be soldered to and may separate semiconductor die 206b and semiconductor die 206c. The spacer 208c may be soldered to and may be disposed on a bottom side of the bottom semiconductor die 206c. As stated above, the spacer 208c may separate the semiconductor die 206c from the lead frame 210a and lead frame 210b. Similar to FIGS. 1A-C discussion above, the spacers 208 may be copper spacers and/or may be any other type of spacers.

Each spacer 208 may be configured to include at least one extended spacer corner feature 214. The spacer corner features may be configured to radially and diagonally (e.g., along an imaginary diagonal line connecting diagonally opposite corners of the spacer) extend away from the center of the spacers and toward corner(s) of the semiconductor die(s) that the spacer is separating. For example, the spacer 208a may be configured to include extended spacer corner features 214 (a, b, c, d) (extended spacer corner features 214b, 214c, and 214d are shown in FIG. 2). The extended spacer corner features 214 may be disposed at each of the corners of the spacer 208a. As shown in FIG. 2, the features 214 may be configured to have a circular, semi-circular, partially circular, round, square, rectangular, triangular, polygonal, etc. shape and/or any combination of shapes. As can be understood, the features 214 may have any other desired shapes. Further, each feature 214 may have its own shape, size, and/or any other dimension that may or may not be different or same as another feature's shape, size, and/or any other dimension. The features 214 may further extend the surface area of the spacer 208a so as to extend over, cover (at least partially) and/or beyond corners of the semiconductor dies 206, thereby avoiding corners of the semiconductor dies 206 from "hanging over" the corners of the spacers and thus, be potentially subject to stresses from bending, packaging, assembly, reliability testing, brittle nature of the silicon material, etc. Such stresses can lead to cracks, which, as discussed herein, typically occur at die edges and/or corners. Critical stress levels semiconductor devices (encapsulated in epoxy molding compound (EMC) and/or plastic packaging) having multiple stacked semiconductor dies may be induced during thermal loading, e.g., due to a mismatch in materials' CTEs (e.g., CTEs of 15-75 ppm/c), with stresses concentrating in corners of devices. As shown in FIG. 2, for instance, the extended spacer corner feature 214c may be configured to provide support and thus, secure corners of both the semiconductor die 206a and the semiconductor die 206b. Each spacer 208 may be configured to include one or more of such extended spacer corner features 214. Alternatively, or in addition, some of the spacers 208 may include features 214 while others do not. Moreover, as discussed herein, the clip 202 may likewise be configured to include one or more extended contact corner features 212 that may provide further protection to the semiconductor dies.

The extended spacer corner features 214 may be configured to extend away from the corners of the respective spacers 208, thus, to or beyond corners of the respective semiconductor dies 206 at various distances, where extension distance of one feature 214 may be different from another feature 214 (either within the same assembly 200, within the same spacer 208, between different spacers 208, etc.).

The clip 202's contact area 204 may, optionally, be configured to include one or more extended contact corner features 212 positioned at at least one corner of the contact area 204. Each of extended contact corner features 212 may be configured to extend over and beyond at least one corner of the top semiconductor die 206a. For example, the contact area 204 may include extended contact corner features 212a, 212b, 212c, and 212d disposed at each of the four corners of the contact area 204. Thus, the extended spacer corner feature(s) 214 of the spacers 208 and/or the extended contact corner features 212 of the contact area 204 of clip 202 may be configured to reduce stress on the at least one semiconductor die 206. Similar to features 214, the features 212 may be configured to have a circular, semi-circular, partially circular, round, square, rectangular, triangular, polygonal, etc. shape and/or any combination of shapes, and/or any other desired shapes. Further, each feature 212 may have its own shape, size, and/or any other dimension that may or may not be different or same as another feature's shape, size, and/or any other dimension. Also, each feature 212 may have its own shape, size, and/or any other dimension that may or may not be different or same as at least one feature 214's shape, size, and/or any other dimension.

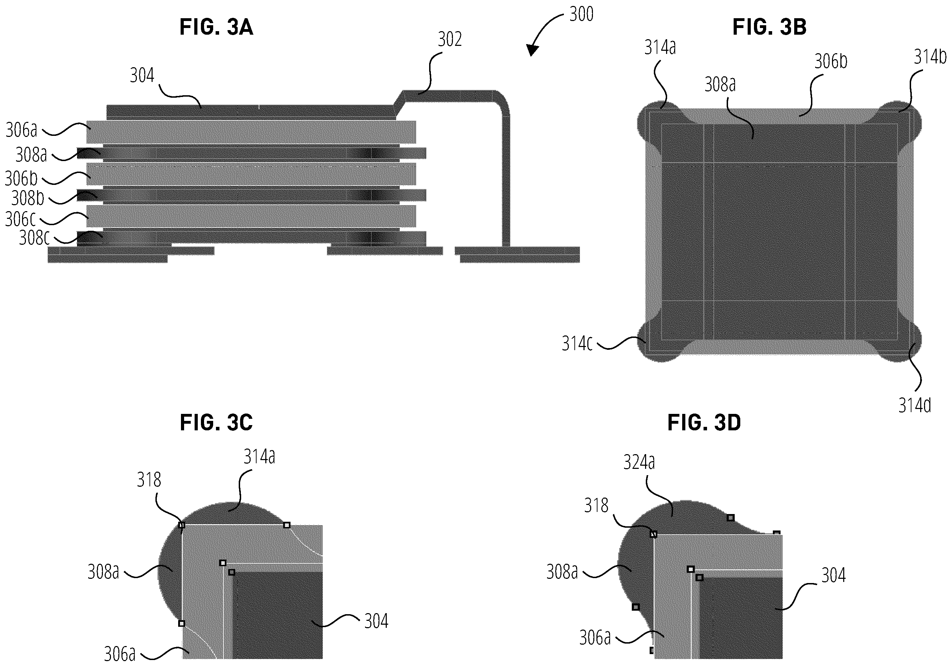

FIGS. 3A-D illustrate an example of a semiconductor assembly 300, according to the current subject matter. FIG. 3A shows a side two-dimensional view of the semiconductor assembly 300. FIG. 3B illustrates a top view of a spacer and a semiconductor die of the semiconductor assembly 300. FIG. 3C illustrates a top view of an extended spacer corner feature of the semiconductor assembly 300. FIG. 3D illustrates a top view of another extended spacer corner feature of the semiconductor assembly 300.

As shown in FIG. 3A, the semiconductor assembly 300 may be similar to the semiconductor assembly 200 shown in FIG. 2. In particular, the semiconductor assembly 300 may include stacked semiconductor dies 306 (a, b, c) separated by spacers 308 (a, b, c), a clip 302 having a contact area 304 or a first end that may be coupled to the top semiconductor die 306a and a second end coupled to a lead frame. The contact area 304 may be configured to cover the entirety (or substantially the entirety) of the top surface of the semiconductor die 306a. One or more lead frames may be used to couple semiconductor assembly 300 to one or more electronic components of a circuit (not shown in FIG. 3A). The semiconductor assembly 300 may be encapsulated into a housing (not shown in FIG. 3A), e.g., an epoxy molding compound housing. Similar to FIG. 2, the spacer(s) 308 may be soldered to adjacent semiconductor die(s) 306 and may be disposed between and adjacent to, and may separate two semiconductor dies 306.

In difference to FIG. 2, the clip 302's contact area 304 may be configured to be without one or more extended contact corner features (e.g., features 212 as shown in FIG. 2) positioned at at least one corner of the contact area 304. This may leave the corners of the semiconductor die 306a exposed, as shown in FIG. 3A.

Referring to FIG. 3B, each spacer 308 may include at least one extended spacer corner feature 314. The spacer corner features may be configured to radially and diagonally extend away from the center of the spacer and toward corner(s) of the semiconductor die(s) that the spacer is separating.

For example, the spacer 308a may be configured to include extended spacer corner features 314 (a, b, c, d) disposed at each of the corners of the spacer 308a. The features 314 may enlarge or extend the surface area of the spacer 308a and may extend over, cover (at least partially) and/or beyond corners of the semiconductor die 306b, as shown in FIG. 3A, which may provide support to the corners of the semiconductor die 306b (and/or other semiconductor dies 306 not shown in FIG. 3B).

As shown in FIGS. 3C and 3D, the extended spacer corner features 314 may be configured to extend away from the corners of the respective spacers 308, thus, to or beyond corners of the respective semiconductor dies 306 at different distances.

For example, as shown in FIG. 3C, the outer edge of the extended spacer corner feature 314a of the spacer 308a may be configured to extend just to the apex of the corner 318 of the semiconductor die 306a, e.g., the apex of the corner 318 of the extended spacer corner feature 314a may lie on the outer edge or circumference of the extended spacer corner feature 314a of the spacer 308a.

Alternatively, or in addition, as shown in FIG. 3D, the outer edge of the extended spacer corner feature 324a of the spacer 308a may be configured to extend beyond the apex of the corner 318 of the semiconductor die 306a. This way the apex of the corner 318 of the extended spacer corner feature 324a may lie within or be enclosed by the surface area of the extended spacer corner feature 324a of the spacer 308a. The corner 318 may be configured to be within a predetermined distance from the outer edge of the extended spacer corner feature 324a. The extended spacer corner feature 324a may be configured to extend outside of the apex of the corner 318 at any desired distance.

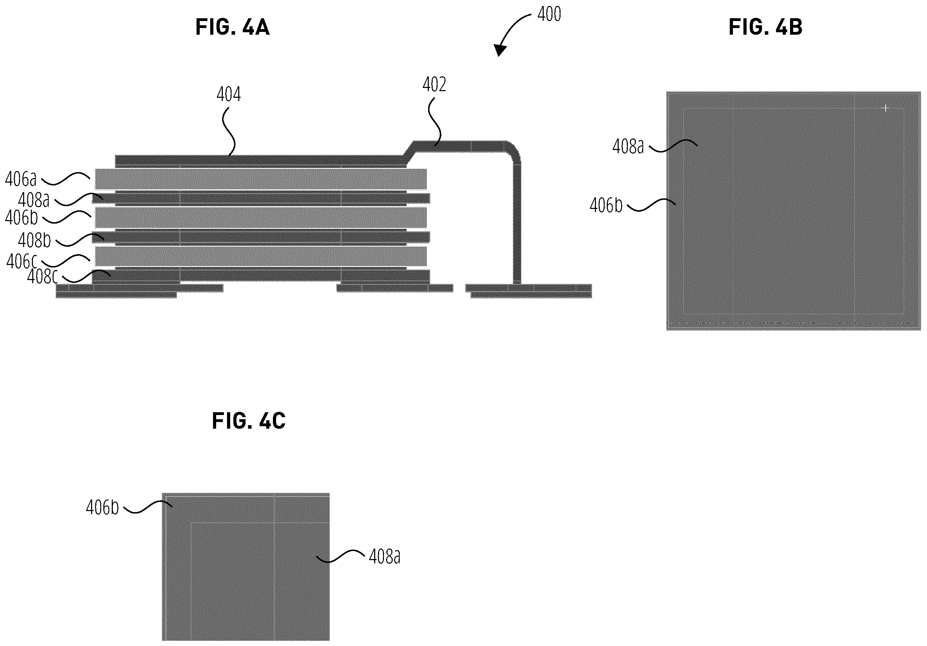

FIGS. 4A-C illustrate another example of a semiconductor assembly 400, according to the current subject matter. FIG. 4A shows a two-dimensional side view of the semiconductor assembly 400. FIG. 4B illustrates a top view of a spacer and a semiconductor die of the semiconductor assembly 400. FIG. 4C illustrates a top view of an example of the spacer of the semiconductor assembly 400.

The semiconductor assembly 400 may be similar to the semiconductor assembly 300 shown in FIGS. 3A-D. The semiconductor assembly 400 may include stacked semiconductor dies 406 (a, b, c) separated by spacers 408 (a, b, c), a clip 402 having a contact area 404 that may be coupled to the top semiconductor die 406a and a second end coupled to a lead frame. The contact area 404 may be configured to cover substantially the entirety of the top surface of the semiconductor die 406a. One or more lead frames to which the spacer 408c may be used to couple semiconductor assembly 400 to one or more electronic components of a circuit (not shown in FIG. 4A). The semiconductor assembly 400 may also be encapsulated into a housing (not shown in FIG. 4A). The spacer(s) 408 may be soldered to adjacent semiconductor die(s) 406 and may be disposed between and adjacent to two semiconductor dies 406.

As shown in FIGS. 4A-C, the clip 402's contact area 404 may be configured to be without one or more extended contact corner features (e.g., features 212 as shown in FIG. 2) positioned at at least one corner of the contact area 404. This may leave the corners of the semiconductor die 406a exposed, as shown in FIG. 4A. Further, as shown in FIGS. 4B and 4C, the spacers 408 may be configured to extend substantially to the edges of the semiconductor dies 406. However, the spacers 408 may be configured to be without extended spacer corner features (similar to those shown in FIGS. 2 and 3A-D).

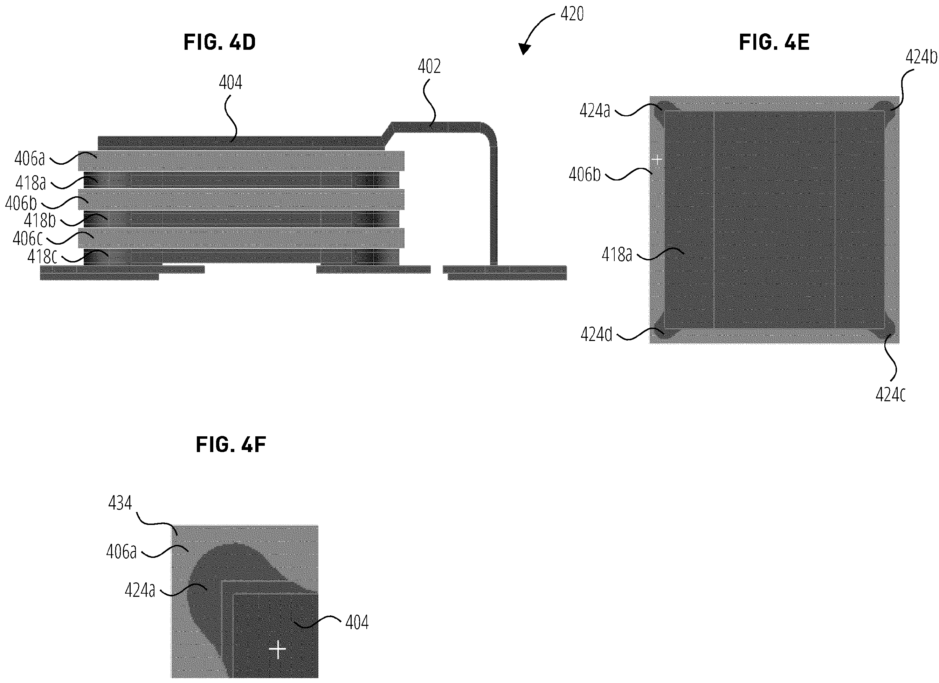

FIGS. 4D-F illustrate another example of a semiconductor assembly 420, according to the current subject matter. FIG. 4D shows a two-dimensional side view of the semiconductor assembly 420. FIG. 4E illustrates a top view of a spacer and a semiconductor die of the semiconductor assembly 420. FIG. 4F illustrates a top view of an example of extended spacer corner feature(s) of the semiconductor assembly 420.

Similar to other semiconductor assemblies discussed herein, the semiconductor assembly 420 may include stacked semiconductor dies 406 (a, b, c) separated by spacers 418 (a, b, c), and a clip 402 having a contact area 404 that may be coupled to the top semiconductor die 406a and a second end coupled to a lead frame. The contact area 404 may be configured to cover substantially the entirety of the top surface of the semiconductor die 406a. Again, one or more lead frames may be used to couple semiconductor assembly 420 to electronic components of a circuit (not shown in FIG. 4D). The semiconductor assembly 420 may also be encapsulated into a housing (not shown in FIG. 4D). The spacer(s) 418 may be soldered to adjacent semiconductor die(s) 406 and may be disposed between and adjacent to, and may separate two semiconductor dies 406.

As shown in FIG. 4E, each spacer 418 may include at least one extended spacer corner feature 424 (a, b, c, d). The extended spacer corner features 424 may be configured to radially and diagonally extend away from the center of the spacer(s) 418 and toward corner(s) of the semiconductor die(s) 406 that the spacer 418 is separating.

For instance, as shown in FIG. 4E, the spacer 418a may include extended spacer corner features 424 (a, b, c, d) disposed at each of the corners of the spacer 418a. The features 424 may enlarge or extend the surface area of the spacer 418a and may extend toward corners of the semiconductor die 406b, as shown in FIG. 4E (as well as semiconductor die 406a as shown in FIG. 4D). In difference to other semiconductor assemblies discussed herein, the corner features 424 do not extend over the corners of the semiconductor die(s) 406 and, instead, may be contained within the surface area of the semiconductor die(s) 406. This design of the features 424 may likewise provide support to the corners of the semiconductor dies 406.

Outer edge(s) of the extended spacer corner feature(s) 424 may be configured to extend to inner edges of the corner 434 of the semiconductor die 406a (as shown in FIG. 4F). Thus, the corner 434 of the semiconductor die 406a may contain the extended spacer corner feature 424a of the spacer 418a without the extended spacer corner feature 424a extending over the corner 434 (as shown, for example, in FIGS. 3A-D).

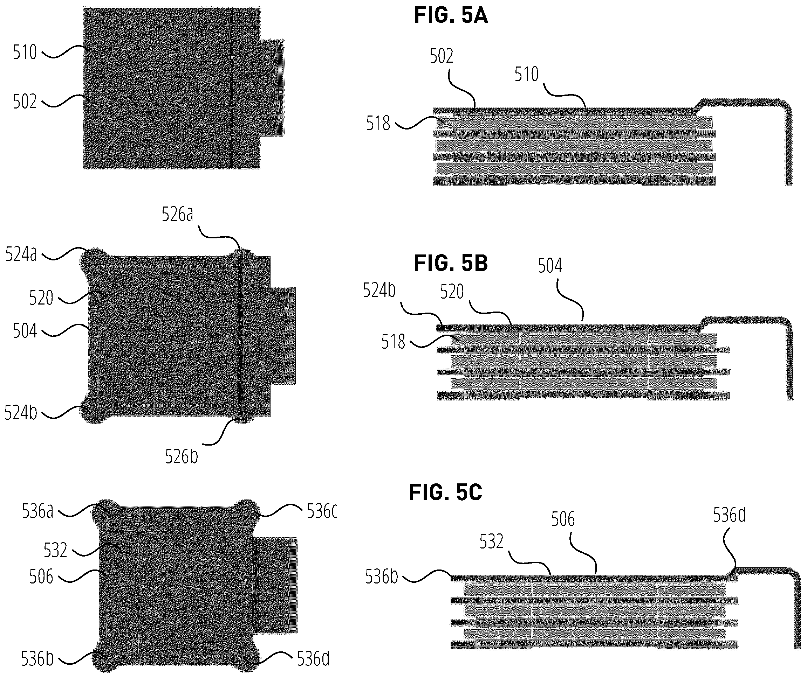

FIGS. 5A-C illustrate examples of semiconductor assemblies 502, 504, and 506, respectively, according to the current subject matter. FIG. 5A shows two-dimensional top and side views of the semiconductor assembly 502. FIG. 5B illustrates top and side two-dimensional views of the semiconductor assembly 504. FIG. 5C illustrates top and side two-dimensional views of the semiconductor assembly 506.

As shown in FIG. 5A, the semiconductor assembly 502 may be similar to the semiconductor assemblies shown and discussed in connection with FIGS. 2-4F, in that it may include one or more semiconductor dies 518 separated by one or more spacers and include a clip 510. The clip 510 may be configured to extend over the entirety of the surface area of the semiconductor dies 518, thereby providing protection to the corners. The surface area of the clip 510 may be same and/or greater than the surface area of the semiconductor dies 518 (e.g., the clip 510 may extend over and/or cover the semiconductor dies 518).

Referring to FIG. 5B, the semiconductor assembly 504 may also be similar to the semiconductor assemblies shown and discussed in connection with FIGS. 2-4F. It may include one or more semiconductor dies 518 and a clip 520. The clip 520 may be configured to include one or more extended contact corner features 524a and 524b (which may be similar to the features 212 shown in FIG. 2). The features 524a and 524b may be positioned over two corners of the semiconductor dies 518, while the other corners of the semiconductor dies 518 may be protected by one or more extended spacer corner features 526a and 526b (which may be similar to the features 214 shown in FIG. 2, for example).

Similarly, as shown in FIG. 5C, the semiconductor assembly 506 may include the clip 532 that may include four extended contact corner features 536a, 536b, 536c, and 536d (which may be similar to the features 212 shown in FIG. 2 and/or features 524 shown in FIG. 5B). The corner features 536 may be configured to protect all four corners of the semiconductor die that may be positioned adjacent to the clip 532. As can be understood, the semiconductor assemblies 502-506 may include clips that may have any number of extended contact corner features (or none).

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the scope of the appended claims.

In one aspect, a semiconductor assembly may include a plurality of semiconductor dies; and a plurality of spacers, each spacer in the plurality of spacers is disposed between and configured to separate two semiconductor dies in the plurality of semiconductor dies; at least one spacer in the plurality of spacers having at least one extended spacer corner feature configured to extend toward at least one corner of at least one semiconductor die in the plurality of semiconductor dies disposed adjacent to the at least one spacer, wherein the at least one extended spacer corner feature is configured to reduce stress on the at least one semiconductor die.

The semiconductor assembly may include wherein the at least one extended spacer corner feature is configured to at least partially cover the at least one corner of the at least one semiconductor die.

The semiconductor assembly may include wherein the at least one extended spacer corner feature is configured to extend over and beyond the at least one corner of the at least one semiconductor die at a first predetermined distance from the at least one corner.

The semiconductor assembly may include wherein the at least one extended spacer corner feature is configured to extend over and beyond the at least one corner of the at least one semiconductor die at a second predetermined distance from the at least one corner, wherein the second predetermined distance is greater than the first predetermined distance.

The semiconductor assembly may include a plurality of lead frames; a clip having a first end coupled to a top semiconductor die in the plurality of semiconductor dies and a second end coupled to a first lead frame in the plurality of lead frames, wherein the top semiconductor die is disposed at a top of the semiconductor assembly.

The semiconductor assembly may include wherein at least one second lead frame in the plurality of lead frames is coupled to a bottom spacer in the plurality of spacers.

The semiconductor assembly may include wherein the clip includes a contact area.

The semiconductor assembly may include wherein the contact area of the clip is configured to extend over an entirety of an area of the top semiconductor die.

The semiconductor assembly may include wherein the contact area of the clip includes at least one extended contact corner feature positioned at at least one corner of the contact area, each the at least one extended contact corner feature is configured to extend over and beyond at least one corner of the top semiconductor die.

The semiconductor assembly may include wherein the at least one spacer is a copper spacer.

The semiconductor assembly may include wherein the at least one extended spacer corner feature has at least one portion having a semicircular shape.

The semiconductor assembly may include a housing configured to encapsulate the plurality of semiconductor dies and the plurality of spacers.

The semiconductor assembly may include wherein the housing is an epoxy molding compound housing.

The semiconductor assembly may include wherein each spacer in the plurality of spacers is soldered to at least one semiconductor die disposed adjacent to the spacer.

In one aspect a packaging structure may include a housing; a plurality of semiconductor dies; a plurality of spacers, each spacer in the plurality of spacers is disposed between and configured to separate two semiconductor dies in the plurality of semiconductor dies; at least one spacer in the plurality of spacers having at least one extended spacer corner feature configured to extend toward at least one corner of at least one semiconductor die in the plurality of semiconductor dies disposed adjacent to the at least one spacer, wherein the at least one extended spacer corner feature is configured to reduce stress on the at least one semiconductor die; and a clip having a first end coupled to a top semiconductor die in the plurality of semiconductor dies and a second end coupled to a lead frame in a plurality of lead frames, wherein the top semiconductor die is disposed at a top of the semiconductor assembly; wherein the housing is configured to encapsulate the plurality of semiconductor dies, the plurality of spacers, the clip, and at least a portion of the plurality of lead frames.

The packaging structure may also include wherein the at least one extended spacer corner feature is configured to at least partially cover the at least one corner of the at least one semiconductor die.

The packaging structure may also include wherein the at least one extended spacer corner feature is configured to extend over and beyond the at least one corner of the at least one semiconductor die at a first predetermined distance from the at least one corner.

The packaging structure may also include wherein the at least one extended spacer corner feature is configured to extend over and beyond the at least one corner of the at least one semiconductor die at a second predetermined distance from the at least one corner, wherein the second predetermined distance is greater than the first predetermined distance.

The packaging structure may also include wherein the clip includes a contact area, the contact area of the clip is configured to cover an entirety of an area of the top semiconductor die, wherein the contact area of the clip includes at least one extended contact corner feature positioned at at least one corner of the contact area, each the at least one extended contact corner feature is configured to extend over and beyond at least one corner of the top semiconductor die.

The packaging structure may also include wherein each spacer in the plurality of spacers is soldered to at least one semiconductor die disposed adjacent to the spacer.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

## Claims

1. A semiconductor assembly, comprising:
a plurality of semiconductor dies; and
a plurality of spacers, each spacer in the plurality of spacers is disposed between and configured to separate two semiconductor dies in the plurality of semiconductor dies;
at least one spacer in the plurality of spacers having at least one extended spacer corner feature configured to extend toward at least one corner of at least one semiconductor die in the plurality of semiconductor dies disposed adjacent to the at least one spacer, wherein the at least one extended spacer corner feature is configured to reduce stress on the at least one semiconductor die.

2. The semiconductor assembly of claim 1, wherein the at least one extended spacer corner feature is configured to at least partially cover the at least one corner of the at least one semiconductor die.

3. The semiconductor assembly of claim 1 or 2, wherein the at least one extended spacer corner feature is configured to extend over and beyond the at least one corner of the at least one semiconductor die at a first predetermined distance from the at least one corner, preferably wherein the at least one extended spacer corner feature is configured to extend over and beyond the at least one corner of the at least one semiconductor die at a second predetermined distance from the at least one corner, wherein the second predetermined distance is greater than the first predetermined distance.

4. The semiconductor assembly of any of the preceding claims, further comprising a plurality of lead frames.

5. The semiconductor assembly of claim 4, further comprising a clip having a first end coupled to a top semiconductor die in the plurality of semiconductor dies and a second end coupled to a first lead frame in the plurality of lead frames, wherein the top semiconductor die is disposed at a top of the semiconductor assembly.

6. The semiconductor assembly of claim 4 or 5, wherein at least one second lead frame in the plurality of lead frames is coupled to a bottom spacer in the plurality of spacers.

7. The semiconductor assembly of any of the claims 5 or 6, wherein the clip includes a contact area.

8. The semiconductor assembly of claim 7, wherein the contact area of the clip is configured to extend over an entirety of an area of the top semiconductor die.

9. The semiconductor assembly of claim 8, wherein the contact area of the clip includes at least one extended contact corner feature positioned at at least one corner of the contact area, and each of the at least one extended contact corner feature is configured to extend over and beyond at least one corner of the top semiconductor die.

10. The semiconductor assembly of any of the preceding claims, wherein the at least one spacer is a copper spacer.

11. The semiconductor assembly of claim 9 or 10, wherein the at least one extended spacer corner feature has at least one portion having a semicircular shape;

12. The semiconductor assembly of any of the preceding claims 4-11, further comprising a housing, preferably configured to encapsulate one or more of the plurality of semiconductor dies, the plurality of spacers, the clip, at least a portion of the lead frames, more preferably wherein the housing is an epoxy molding compound housing.

13. The semiconductor assembly of any of the preceding claims, wherein each spacer in the plurality of spacers is soldered to at least one semiconductor die disposed adjacent to the spacer.

14. A packaging structure, comprising a semiconductor assembly according to any of the preceding claims.

15. Use of the semiconductor assembly according to any of the claims 1-13, or the packaging structure of claim 14, for corner stress reduction.
